Europäisches Patentamt

European Patent Office

Office européen des brevets

(11) Numéro de publication: **0 001 952**

**B1**

# FASCICULE DE BREVET EUROPEEN

(21) Numéro de dépôt: 78400155.4

(22) Date de dépôt: 27.10.78

(51) Int. Cl.³: **H 01 L 31/00  H 01 L 33/00**

(54) Diode émettrice et réceptrice de rayons lumineux de même longueur d'onde prédéterminée

(30) Priorité: 07.11.77 FR 7733354

(43) Date de publication de la demande:
16.05.79 Bulletin 79/10

(45) Mention de la délivrance du brevet:
10.12.80 Bulletin 80/25

(84) Etats contractants désignés:
DE GB NL

(56) Documents cités:
FR - A - 2 273 371
FR - A - 2 275 078

(73) Titulaire: "THOMSON-CSF"-SCPI
173, Boulevard Haussmann
F-75360 Paris Cedex 08 (FR)

(72) Inventeur: Hirtz, Pierre
"THOMSON-CSF"-SCPI
173, bld Haussmann

(74) Mandataire: Wang, Pierre, et al
"THOMSON-CSF"-SCPI
173, bld Hausmann

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

Diode émettrice et réceptrice de rayons lumineux de même longueur
d'onde prédéterminée

La présente invention a pour objet une diode émettrice et réceptrice de rayons lumineux de même longueur d'onde prédéterminée.

On sait, que notamment dans le domaine des télécommunications par fibres optiques, on utilise des diodes électroluminescentes ou émettrices, qui, quand elles sont polarisées en direct, émettent des rayons lumineux. . Ces rayons transportent une information. A la réception, une diode polarisée en inverse, délivre un courant électrique qui est fonction de l'intensité des rayons lumineux.

On a déjà préconisé d'utiliser la même diode pour assurer les deux fonctions en alternat, notamment dans la publication FR-A-2 275 308 de la demande de brevet français 74.20 716 déposée le 14 Juin 1974 par la demanderesse. Ce problème est difficile à résoudre, les qualités exigées dans les deux fonctions étant contradictoires en certains points, si l'on désire des rendements optimaux en émission et en réception.

En effet, la zone émissive doit avoir une épaisseur faible pour ne pas absorber les photons qu'elle engendre. Elle doit être fortement dopée pour avoir un temps de réponse suffisamment faible. Par contre, la zone réceptrice doit avoir une épaisseur assez grande pour absorber les photons, et créer en conséquence un courant électrique et avoir un assez faible dopage pour être au moins en partie en charge d'espace quand la tension de polarisation inverse est appliquée. De plus, ces deux couches doivent être de bandes interdites de largeur différente. Ces conditions, on le voit sont contradictoires. La diode émettrice et réceptrice de lumière selon l'invention permet de résoudre ce problème. La diode émettrice et réceptrice selon l'invention se caractérise principalement par la superposition d'une première couche émettrice d'un premier type de conductivité et d'une deuxième couche réceptrice d'un second type de conductivité opposé au premier, la largeur de bande interdite de la couche réceptrice étant inférieure à celle de la couche émettrice, une troisième couche de largeur de bande interdite supérieure à celles des première et deuxième couches étant interposée entre celles-ci.

L'invention sera mieux comprise au moyen de la description ci-après en se référant aux dessins annexés parmi lesquels:

La figure 1 représente très schématiquement un premier exemple de diode selon l'invention.

La figure 2 représente les niveaux d'énergie au repos dans une telle diode.

La figure 3 représente les niveaux d'énergie de la même diode en polarisation directe.

La figure 4 représente les niveaux d'énergie de la même diode en régime de polarisation inverse.

Les figures 5, 6, 7, 8, 9 et 10 représentent en coupe respectivement des exemples de réalisation de l'invention.

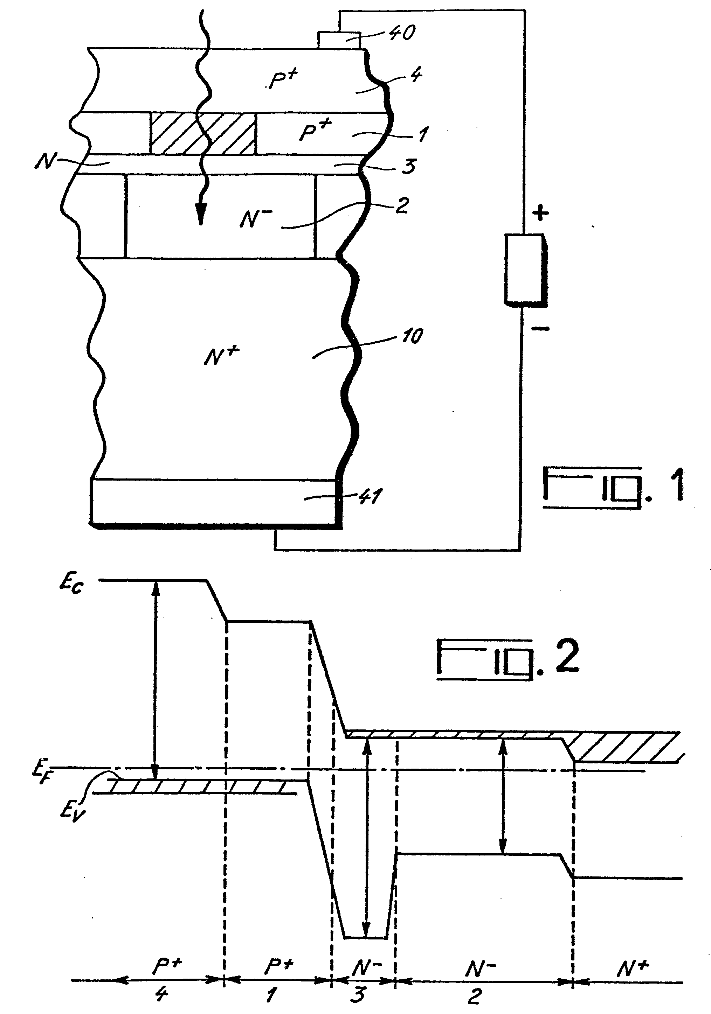

Sur la figure 1, sur un substrat 10 de type $N^+$, on a déposé quatre couches de composition chimiques, et par conséquent de largeur de bandes interdites différentes, à savoir dans l'ordre, les couches 2 de type $N^-$, 3 de type $N^-$ ou N, 1 de type $P^+$ et 4 de type $P^+$ également. La couche 4 d'épaisseur de l'ordre de 1 $\mu$m est exposée aux rayons lumineux que la diode doit détecter quand elle est polarisée en inverse, et c'est de cette face que sont émis les rayons lumineux, sensiblement de même longueur d'onde, quand elle est polarisée en direct. A titre d'exemple non limitatif, le substrat et la couche 2 sont faits en Arséniure de Gallium GaAs, les couches 1, 3 et 4 d'alliage $Ca_{1-x}, Al_x, As$.

La couche 4 a une largeur de bande interdite très grande, de l'ordre de 1,8 eV, une épaisseur de l'ordre de 1 $\mu$m, la couche 1, une largeur de bande interdite plus faible de l'ordre de 1,5 eV, la couche 3 d'épaisseur de l'ordre de 0,3 $\mu$m a une largeur de bande interdite beaucoup plus grande 1,8 eV, par exemple, la couche 2 d'épaifsseur de l'ordre de 2 $\mu$m a la largeur de bande interdite la plus faible, 1,4 eV et enfin le substrat une largeur de bande interdite de l'ordre de 1,4 eV, et une épaisseur de 10 à 200 $\mu$m.

La figure 2 représente quand il n'y a pas de polarisation extérieure, les niveaux d'énergie $E_c$ et $E_v$ des bandes de conduction et des bandes de valence des diverses régions.

Sur cette figure, la ligne en traits interrompus $E_f$ représente le niveau de Fermi. On voit clairement que la zone 3 insérée entre les zones 1 et 2 définit une barrière de potentiel avec la zone 1. Les niveaux d'énergie occupés dans les bandes de valence des régions 1 et 4 correspondent à un dopage de type P.

De même, les niveaux d'energie occupés dans la bande de conduction des zones 3 et 2 correspondent à un dopage de type N. Ces niveaux d'énergie n'étant occupés que de part et d'autre de la jonction, aucun courant électrique ne passera.

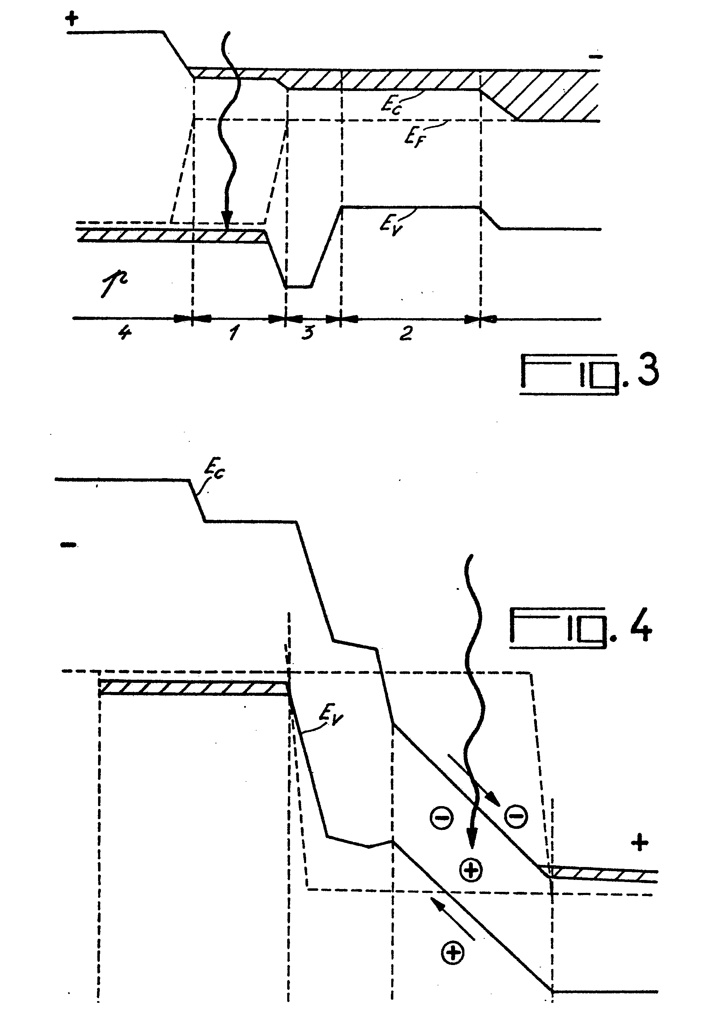

Sur la figure 3, on a représenté les niveaux d'énergie de la même manière avec une polarisation directe.

Sur cette figure, on voit clairement qu'il y a dans la zone 1, à la fois dans les bandes de valence et de conduction, respectivement des trous et des électrons en excès. En se recombinant, ces trous et ces électrons donnent naissance au phénomène d'électroluminescence par le création de photons. Les trous ne peuvent franchir la barrière formée par la bande de valence dans la zone 3, et les électrons la barrière formée par la bande de conduction dans la zone 4. La fréquence de rayonnement est proportionnelle à la largeur de la bande interdite dans la zone 1. L'épaisseur de la zone 1, de l'ordre de 1 $\mu$m et son dopage de l'ordre de $10^{18}$ at/cm$^3$, sont choisis de façon optimale, pour que le rendement en photo-émission et la vitesse de modulation de la diode soient les plus grandes possible.

Sur la figure 4, les niveaux d'énergie $E_v$ et $E_c$ sont représentés dans le cas d'une forte polarisation inverse; la zone 4 est reliée au pôle — d'une source de polarisation, le substrat à son pôle +. Il en résulte que les barrières de potentiel sont accentuées au voisinage de la jonction, et que les zones 3 et surtout 2 sont en charge d'espace. Un photon traversant les zones 4, 1 et 3 sans être absorbé en raison de leurs largeurs de bande interdite respectives relativement grandes, est absorbé dans la zone 2 de bande interdite plus faible. Il donne naissance à un trou qui va vers le pôle — et à un électron qui va vers le pôle +. C'est donc la zone 2 qui est essentiellement le siège de la photodétection. Cette zone peut donc avoir une épaisseur suffisante, 2 $\mu$m par exemple pour absorber les photons, et un dopage faible $10^{15}$ at/cm$^3$ par exemple, pour être facilement mise en charge d'espace. Le rôle de la zone 3 est de former les barrières nécessaires pour séparer les deux fonctions: émission et réception. Son épaisseur 0,3 $\mu$m par exemple peut être faible. C'est essentiellement sa largeur de bande interdite qui doit être grande et son dopage suffisament faible pour que la charge d'espace s'étende dans la couche 2.

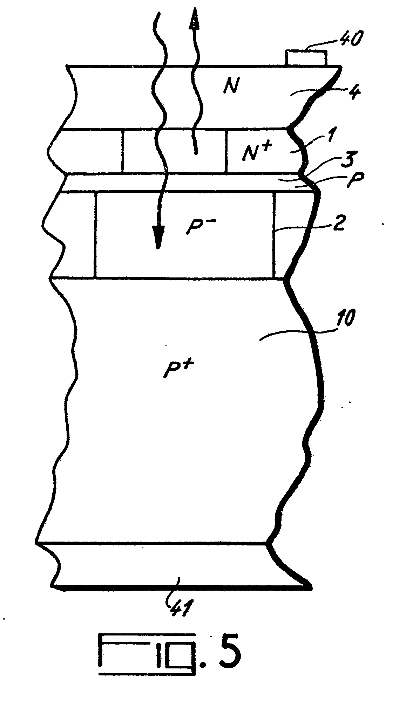

La figure 5 représente une diode selon l'invention, dans laquelle tous les types de conductivité sont inversés. Par ailleurs, la conception en est identique.

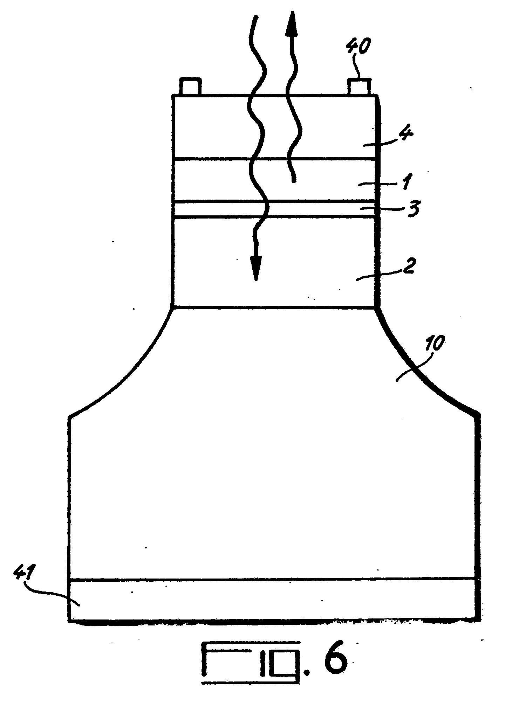

La figure 6 représente un exemple de réalisation en forme de "mésa", la zone 4 exposée au rayonnement lumineux comporte un contact annulaire 40. Le substrat 10 comporte sur sa surface libre un contact 41.

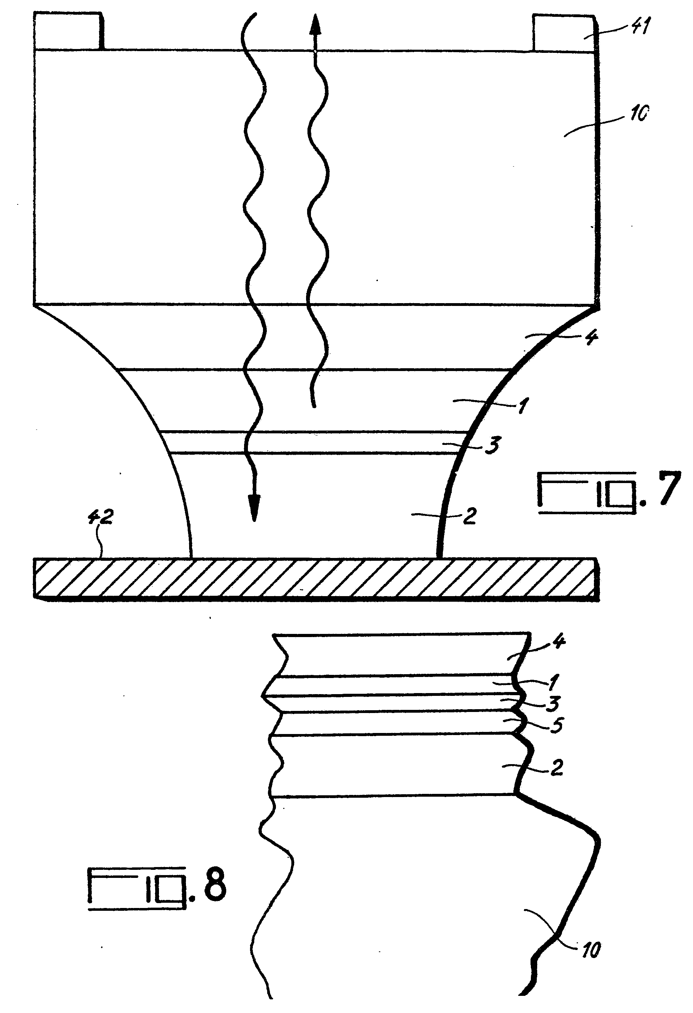

Un autre exemple de réalisation est représenté sur la figure 7. Le substrat 10 est transparent et sa face libre est exposée aux radiations. La disposition des couches 1, 2, 3 et 4 est inversée par rapport aux figures précédentes. La couche 2 est soudée sur un support métallique 42, qui sert à la fois de radiateur de chaleur et de contact: cette disposition favorise l'évacuation de la chaleur. La diode est du type dit "diode" mésa "soudée à l'envers".

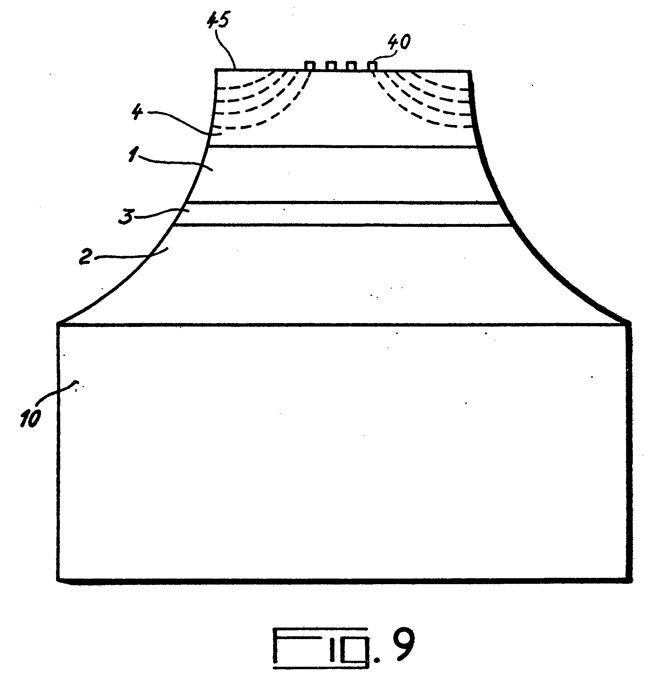

Sur la figure 8, une couche 5 de type N, à petite bande interdite, est interposée entre les zones 2 et 3, elle peut servir de couche de multiplication par avalanche des électrons engendrés dans la couche 2. En dopant plus fortement la couche 3 que la couche 2, le phénomène d'avalanche pourra se produire dans la couche 3. Mais au cas où ce dopage devient trop élevé, il peut être difficile de mettre les couches 2 et 3 en charge d'espace. La présence de la couche 5 de la figure 8 permet de résoudre ce problème.

Il y a lieu de remarquer que dans le cas d'alliage du type Ga$_{1-x}$, Al$_x$, As, la largeur de bande interdite est fonction croissante de la valeur x. Dans les exemples décrits plus haut, les couches 1, 2, 3 et 4 auront par exemple des valeurs x respectivement de 0,07, pour la couche 1, voisine de 0 pour la couche 2, de 0,3 pour les couches 3 et 4. On peut espérer, par un traitement antiréfléchissant, c'est-à-dire par le dépôt sur la surface libre de la diode (zone 4 ou substrat) d'une couche diélectrique d'épaisseur quart-d'onde de type connu, une sensibilité voisine de 100 A par watt.

Le temps de réponse à la réception peut être faible puisque tous les porteurs sont créés dans la zone en charge d'espace; donc aucun processus de diffusion naturelle n'intervient. Enfin, le temps de transit des porteurs crées dans la zone en charge d'espace, d'épaisseur de l'ordre de 2 $\mu$m peut être inférieur à 100 ps.

Bien entendu, toutes les valeurs indiquées sont données à titre d'exemple. De plus, d'autres matériaux que les alliages de type Ga, Al, As peuvent être utilisés, par exemple des structures à base de mélanges ternaires ou quaternaires pris dans les groupes 3 et 5 de la classification de Mendeleïef.

Enfin la figure 9 représente une structure combinant les solutions décrites dans cette demande et dans la demande de brevet français déposée le 18 Octobre 1977 sous le No. 77 31 274 par la demanderesse et à laquelle correspond la demande de brevet européen déposée sous le numéro 78400120.8 et publiée sous le numero 1728. Sur la couche 4, une zone 45 annulaire et rendue isolante est prévue qui permet de concentrer à l'émission les lignes de courant dans la partie centrale de la diode.

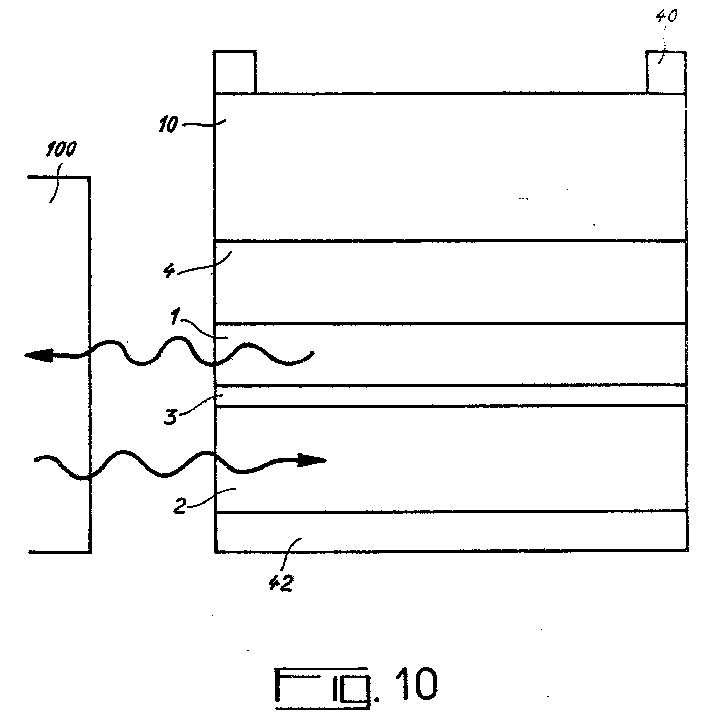

L'invention peut également être étendue à des structures laser semi-conducteur, Fig. 10. Dans ce cas, l'ensemble est un monocristal clivé sur deux faces. La fibre 100 est couplée de la façon indiquée, les couches 2 et 1 recevant et émettant la radiation lumineuse par la tranche.

**Revendications**

1. Diode émettrice et réceptrice de rayons lumineux de même longeur d'onde prédéterminée, caractérisée par la superposition d'une première couche émettrice (1) d'un premier type de conductivité, et d'une deuxième couche (2) réceptrice d'un deuxième type de conductivité opposé au premier, la largeur de bande interdite de la deuxième couche étant inférieure à celle de la première couche, une troisième couche (3) de largeur de bande interdite supérieure à celle des deux premières étant interposée entre la première et la deuxième couche.

2. Diode selon la revendication 2, caractérisée en ce que ledit premier type de conductivité est le type P.

3. Diode selon la revendication 2, caractérisée en ce que ledit premier type est le type N.

4. Diode selon la revendication 1, caractérisée en ce que la première couche (1) supporte une quatrième couche (4) du premier type de conductivité, et de largeur de bande interdite supérieure à celle des premières et deuxièmes couches (1 et 2).

5. Diode selon la revendication 4, caractérisée en ce que les bandes interdites desdites troisième et quatrième couches (3 et 4) sont du même ordre de grandeur.

6. Diode selon la revendication 5, caractérisée en ce qu'une cinquième couche (5) de même type de conductivité que la couche (2) réceptrice est interposée entre la deuxième et la troisème couches, la bande interdite de ladite cinquième couche étant telle que cette dernière peut servir à la multiplication par avalanche.

7. Diode selon la revendication 4, caractérisée en ce que la quatrième couche (4) est directement soumise à l'impact des rayons lumineux.

8. Diode selon la revendication 4, caractérisée en ce que la quatrième couche (4) est déposée sur un substrat (10) transparent auxdits rayons lumineux, ladite deuxième couche supportant un contact métallique (42) capable d'évacuer la chaleur.

9. Diode selon la revendication 4, caractérisée en ce qu'elle est délimitée par deux faces extrêmes clivées et formant ainsi un "laser" semiconducteur émettant la lumière par une des faces clivées.

10. Diode selon la revendication 2, caractérisée en ce que les diverses couches sont faites d'alliages ternaires ou quaternaires des groupes III et V.

11. Diode selon la revendication 10, caractérisée en ce que les diverses couches sont faites d'alliage du type $Ga_{1-x}Al_x As$, la largeur de bande interdite étant fonction croissante de la valeur x.

**Claims**

1. Diode for emitting and receiving light rays of the same predetermined wave length, characterized by the superposition of a first emitting layer (1) of a first conductivity type and a second receiving layer (2) of a second conductivity type opposite to the first, the width of the forbidden band of the second layer being smaller than that of the first layer, a third layer (3) the forbidden band width of which exceeds those of the first two layers being interposed between the first and the second layers.

2. Diode in accordance with claim 1, characterized in that the first conductivity type is the P-type.

3. Diode in accordance with claim 2, characterized in that said first type is the N-type.

4. Diode in accordance with claim 1, characterized in that said first layer (1) is supporting a fourth layer (4) of the same conductivity type and having a forbidden band width exceeding that of the first and second layers (1 and 2).

5. Diode in accordance with claim 4, characterized in that the forbidden bands of said third and fourth layers (3 and 4) are of the same order of dimension.

6. Diode in accordance with claim 5, characterized in that a fifth layer (5) of the same conductivity type as the receiving layer (2) is interposed between the second and third layers, the forbidden band of the fifth layer being such that the latter may serve for multiplication by avalanche.

7. Diode in accordance with claim 4, characterized in that the fourth layer (4) is directly exposed to the impingement of the light rays.

8. Diode in accordance with claim 4, characterized in that the fourth layer (4) is deposited on a substrate (10) which is transparent to the light rays, said second layer supporting a metal contact (42) adapted for heat dissipation.

9. Diode in accordance with claim 4, characterized in that it is defined by two cleaved end faces, thus forming a "laser" semiconductor emitting light through one of the cleaved faces.

10. Diode in accordance with claim 2, characterized in that the various layers are made from ternary or quaternary alloys of groups III and V.

11. Diode in accordance with claim 10, characterized in that the various layers are made of alloys of the type $Ga_{1-x}Al_xAs$, the width of the forbidden band being an increasing function of the value x.

**Patentansprüche**

1. Diode zum Aussenden und Empfangen von Lichtstrahlen derselben vorbestimmten Wellenlänge, gekennzeichnet, durch die Über-einanderanordnung einer ersten, aussenden-den Schicht (1) eines ersten Leitungstyps und einer zweiten, empfangenden Schicht (2) eines zweiten, dem erstgenannten Leitungstyp entgegengesetzten Leitungstyps, wobei die Breite des verbotenen Bandes der zweiten Schicht geringer ist als diejenige der ersten Schicht und wobei eine dritte Schicht (3), deren Breite des verbotenen Bandes größer ist als diejenige der beiden erstgenannten, zwischen der ersten und der zweiten Schicht angeordnet ist.

2. Diode nach Anspruch 1, dadurch gekennzeichnet, daß der erste Leitungstyp der P-Typ ist.

3. Diode nach Anspruch 2, dadurch gekennzeichnet, daß der erste Typ der N-Typ ist.

4. Diode nach Anspruch 1, dadurch gekennzeichnet, daß die erste Schicht (1) eine vierte Schicht (4) des ersten Leitungstyps trägt, bei der die Breite des verbotenen Bandes größer ist als diejenige der ersten und der zweiten Schicht (1 und 2).

5. Diode nach Anspruch 4, dadurch gekennzeichnet, daß die verbotenen Bänder der dritten und der vierten Schicht (3 und 4) dieselbe Größenordnung haben.

6. Diode nach Anspruch 5, dadurch gekennzeichnet, daß eine fünfte Schicht (5) desselben Leitungstyps wie die empfangende Schicht (2) zwischen der zweiten und der dritten Schicht angeordnet ist, wobei das verbotene Band der fünften Schicht derart ausgelegt ist, daß diese zur Vervielfachung durch den Avalanche-Effekt dienen kann.

7. Diode nach Anspruch 4, dadurch gekennzeichnet, daß die vierte Schicht (4) direkt dem Auftreffen der Lichtstrahlen ausgesetzt ist.

8. Diode nach Anspruch 4, dadurch gekennzeichnet, daß die vierte Schicht (4) auf einem für die Lichtstrahlen durchlässigen Substrat (10), abgelagert ist, wobei die zweite Schicht einen zur Wärmeabführung geeigneten Metallkontakt (42) trägt.

9. Diode nach Anspruch 4, dadurch gekennzeichnet, daß sie durch zwei abgespaltene Endflächen begrenzt ist und auf diese Weise einen Halbleiter-"Laser" bildet, der das Licht durch eine seiner abgespaltenen Flächen emittiert.

10. Diode nach Anspruch 2, dadurch gekennzeichnet, daß die verschiedenen Schichten aus dreistoffigen oder vierstoffigen Legierungen der Gruppen III und V gebildet sind.

11. Diode nach Anspruch 10, dadurch gekennzeichnet, daß die verschiedenen Schichten aus Legierungen des Typs $Ga_{1-x}Al_xAs$ gebildet sind, wobei die Breite des verbotenen Bandes eine zunehmende Funktion des Wertes x ist.

**Fig. 1**

**Fig. 2**

0 001 952

FIG. 3

FIG. 4

N

40

4

N⁺

1

3

P

P⁻

2

10

P⁺

41

Fig. 5

0 001 952

# FIG. 6

4

FIG.7

FIG.8

FIG. 9

$\boxed{\text{F}|\text{□}}$. 10